Europäisches Patentamt

European Patent Office

Office européen des brevets

(11) Publication number: **0 185 590**
**A2**

## (12) EUROPEAN PATENT APPLICATION

(21) Application number: **85402479.1**

(22) Date of filing: **12.12.85**

(51) Int. Cl.⁴: **C 08 J 5/12**
**B 29 C 71/04**
**//B32B27/08**

(30) Priority: **14.12.84 JP 264785/84**

(43) Date of publication of application:
**25.06.86 Bulletin 86/26**

(84) Designated Contracting States:
**DE FR GB**

(71) Applicant: Shin-Etsu Chemical Co., Ltd.
6-1, Ohtemachi 2-chome
Chiyoda-ku Tokyo 100(JP)

(72) Inventor: Ueno, Susumu c/o Dogou Shataku 3-308
9809-7, Yatabe, Hazaki-cho
Kashima-gun Ibaraki-ken(JP)

(72) Inventor: Kuroda, Kouiti c/o Dogou Shataku 1-103
9809-7, Yatabe, Hazaki-cho
Kashima-gun Ibaraki-ken(JP)

(72) Inventor: Kitamura, Hajime
6-14-2, Aobadai
Ichihara-shi Chiba-ken(JP)

(74) Representative: Armengaud, Alain et al,
Cabinet ARMENGAUD AINE 3 Avenue Bugeaud
F-75116 Paris(FR)

(54) A method for the preparation of a laminated film.

(57) The invention provides a method for the preparation of a laminate of a polyimide resin film and a film of a fluorocarbon resin such as a copolymeric resin of tetrafluoroethylene and hexafluoropropylene very firmly bonded together. The inventive method comprises subjecting the surface of each of the polyimide and fluorocarbon resin films to a treatment with low temperature plasma of an inorganic gas before press-bonding the films at an elevated temperature. It is preferable that the thus prepared laminate is further subjected to a heat treatment under a tensioned condition at a temperature higher than the softening point of the fluorocarbon resin so that the laminate can no longer be separated by peeling into the base films of the polyimide and fluorocarbon resins.

EP 0 185 590 A2

Croydon Printing Company Ltd.

0185590

# A METHOD FOR THE PREPARATION OF A LAMINATED FILM

## BACKGROUND OF THE INVENTION

The present invention relates to a method for the preparation of a laminated film or, more particularly, to a method for the preparation of a laminate of films of a polyimide resin and a fluorocarbon resin very firmly bonded together by pressing at an elevated temperature wihout leaving air bubbles included therebetween.

As is well known, a polyimide resin film is a material having various kinds of excellent properties such as heat resistance, electric characteristics, mechanical strengths and others though with some disadvantages of lack of heat sealability as a consequence of the thermosetting nature of polyimide resins as well as low moisture resistance.

The above mentioned problems in polyimide resin films can be partly solved by combining a polyimide resin film with a fluorocarbon resin such as a copolymeric resin of tetrafluoroethylene and hexafluoropropylene or by making a composite film of a polyimide resin and a fluorocarbon resin. A known method for the preparation of such a composite film is to coat the surface of a polyimide resin film with an aqueous dispersion or emulsion of the fluorocarbon resin followed by drying and baking to form a film of the fluorocarbon resin. A practical problem in this method is that no sufficient thickness of the fluorocarbon resin film can be obtained by a single coating so that the above mentioned procedure of coating, drying and baking must be repeated several times in order to have a desired thickness of the coating film. Therefore, this method is industrially not always advantageous due to the low productivity.

In view of the above mentioned problem in the preparation of a composite film of a polyimide resin and a fluorocarbon resin by the method of coating, an alternative method is proposed in which a polyimide resin film and a fluorocarbon resin film are bonded together to form a laminate. This method is also not free from difficulties mainly due to the very poor adhesion of these two different types of resins. For example, no satisfactory bonding can be obtained between them even by pressing the films together at a temperature of the softening point of the fluorocarbon resin or higher. An attempt for the improvement in this regard has been proposed by subjecting the surfaces of the base films to an oxidation treatment or corona discharge treatment but no practically satisfactory results have been obtained yet. The films can of course be adhesively bonded together by use of an adhesive but none of the currently available adhesives provides an adhesively bonded laminate of a polyimide resin film and a fluorocarbon resin film which can withstand a temperature of 300 to 350 °C where heat sealing of the laminated film is usually performed. Therefore, the use of an adhesive also

- 3 -        0185590

cannot be a practical method in consideration of the expected applications of the polyimide-based laminated film in which high heat resistance is essential.

## SUMMARY OF THE INVENTION

An object of the invention is therefore to provide a method for the preparation of a composite film having a laminated structure of films of a polyimide resin and a fluorocarbon resin very firmly bonded together without the problems and disadvantages in the above described prior art methods.

Thus, the method of the present invention for the preparation of a laminate of films of a polyimide resin and a fluorocarbon resin comprises the steps of:

(a) subjecting at least one of the surfaces of each of a polyimide resin film and a fluorocarbon resin film to a treatment with low temperature plasma of an inorganic gas; and

(b) pressing the thus plasma-treated films laid one on the other with the surfaces treated with low temperature plasma contacting with each other at an elevated temperature to integrate the films.

It is preferable that the above mentioned steps (a) and (b) are followed by an additional step (c) in which the press-bonded laminate of the films is subjected to a heat treatment at a temperature of the softening point of the fluorocarbon resin or higher under a tensioned condition.

## DETAILED DESCRIPTION OF THE PREFERRED EMBODIMENTS

As is understood from the above given summarizing description, a polyimide resin film is press-bonded with a fluorocarbon resin film after a low temperature plasma treatment of the surface to form a laminate. Several kinds of fluorocarbon resins are suitable for the fluorocarbon resin film including poly(tetrafluoroethylene), poly(chloro trifluoroethylene), poly(vinyl fluoride), poly(vinylidene fluoride), copolymers of tetrafluoroethylene and hexafluoropropylene, copolymers of chloro trifluoroethylene and vinylidene fluoride and the like, of which copolymeric resins of tetrafluoroethylene and hexafluoropropylene are particularly preferred in the inventive method.

The first step, i.e. step (a), of the inventive method is a low temperature plasma treatment of at least one of the surfaces of each of the polyimide resin film and the fluorocarbon resin film. It is of coruse optional that both surfaces of each film are subjected to the low temperature plasma treatment according to need. The procedure for the low temperature plasma treatment is well known in the art. Namely, the resin film under treatment is placed in a plasma chamber connected to a vacuum line and equipped with discharge electrodes and a high frequency electric power at a frequency of, for example, 10 kHz to 100 MHz is impressed between the electrodes while the atmosphere inside the plasma chamber is controlled and maintained at a reduced pressure of, for example, 0.003 to 30 Torr or preferably, 0.01 to 10 Torr by the balance of continuous introduction of an inorganic gas and continuous evacuation through the vacuum line. The frequency band of the power supply is not limited to the above mentioned high frequency but direct current, low frequency and microwaves can also be used.

The discharge electrodes are installed preferably inside the plasma chamber although they can be installed outside the plasma chamber according to need. A single high frequency work coil surrounding the plasma chamber can also be used as the electrode. The electrodes are connected to the high frequency generator either by capacitive coupling or by inductive coupling. At any rate, it is essential to avoid localized excessive temperature elevation by the heat of electric discharge in order to minimize thermal denaturation of the resin films under treatment.

The form of the electrodes is not particularly limitative including plate-like, ring-like, rod-like and cylindrical ones. The grounded and input electrodes can be of the same form or different forms from each other. A possible design of the plasma chamber is that the inner walls of the plasma chamber are made of a metal to serve as the grounded electrode with an input electrode installed inside the chamber. The material of the electrodes may be a metal of copper, iron, aluminum and the like. It is preferable that the surface of the electrodes or, in particular, the input electrode is provided with a heat-resistant insulating coating having a dielectic strength of at least 10,000 volts/mm. The material of such an insulating coating may be glass, porcelain enamel, ceramic and the like.

The electric power to be supplied to the electrodes should be determined in such a range that the surface of the resin film is efficiently activated but no thermal decomposition or denaturation takes place on the surface of the treated resin film since otherwise the bondability of the resin films may be greatly decreased. When the electric power supplied to the electrodes is so large as to generate excessively intensive low temperature plasma, a copolymeric resin film of tetrafluoroethylene and hexafluoropropylene, in particular, may be subject to thermal decomposition and partial crosslinking of the surface layer so that the softening point of the resin is somewhat increased to cause certain difficulty and inefficiency in the press-bonding of the resin films with heating. Needless to say, a too small electric power supply is undesirable because the desired effect by the low temperature plasma treatment can hardly be obtained with such a small power or an unduly long time is taken for the effective low temperature plasma treatment to cause economical disadvantages.

The inorganic gas suitable for supporting the plasma discharge inside the plasma chamber in the inventive method is exemplified by helium, neon, argon, nitrogen, nitrous oxide, nitrogen dioxide, oxygen, air, carbon monoxide, carbon dioxide, hydrogen, chlorine, hydrogen chloride, sulfur dioxide, hydrogen sulfide and the like. These inorganic gases may be used either singly or as a mixture of two kinds or more according to need. The inorganic gas is preferably nitrogen, oxygen or air in order to improve the bondability of the resin films by fusion. In particular, mixtures of nitrogen and oxygen including air are preferable as the plasma-supporting inorganic gas when the treated film is a copolymeric resin film of tetrafluoroethylene and hexafluoropropylene.

The pressure inside the plasma chamber filled with the above mentioned inorganic gas should be maintained and controlled in the range from 0.003 to 30 Torr or, preferably, from 0.01 to 10 Torr. When the resin film under treatment is a copolymeric resin film of tetrafluoroethylene and hexafluoropropylene, in particular, better results can be obtained by maintaining the pressure within a relatively high range of, for example, at least 0.1 Torr.

In the step (b) to follow, the films of the polyimide and fluorocarbon resins after the low temperature plasma treatment in the above described manner are then laid one on the other and bonded together by pressing at an elevated temperature using a suitable apparatus for press-bonding such as a hot press roller. It is of course that, when only one of the surfaces of each resin film has been treated with the low temperature plasma, the resin films must be laid in such a manner that the plasma-treated surfaces of both films are contacted each with the other. The temperature of the resin films at the press-bonding should be in the range from 100 ºC to the softening point of the fluorocarbon resin or, preferably, in the range from 150 to 230 ºC. It is essential in this process of press-bonding that no air bubbles are left between the resin films because any tiny air bubble included therebetween may cause local peeling of the films during use of the laminate at an elevated temperature or in the course of the subsequent step (c) of the heat treatment of the laminate under a tensioned condition due to the great volume expansion of the included air bubbles. The reason for the above mentioned limitation in the temperature at which the press-bonding is performed, which has been discovered as a result of the extensive investigations, is that a temperature higher than the softening point of the fluorocarbon resin may cause appearance of air bubble inclusions and creases of the resin films as a result of softening and deformation of the fluorocarbon resin film to give no satisfactory product of the laminate. It is an essential condition in this step of press-bonding that both of the surfaces of the polyimide resin and fluorocarbon resin have been treated with low temperature plasma in order to attain satisfactory bonding therebetween.

It is a quite surprising discovery unexpected from the knowledge in the conventional technology of lamination that a fluorocarbon resin film can be completely bonded to a polyimide resin film to form a laminate at a temperature substantially lower than the softening point of the fluorocarbon resin when and only when the surfaces of both films have been subjected to the treatment with low temperature plasma of an inorganic gas. The thus plasma-treated resin films can be press-bonded at an elevated temperature using a hot press roller at such a low pressure that the air bubbles remaining between the resin films can be completely squeezed out but not larger. For example, quite satisfactory bonding of the resin films can be obtained usually with a linear pressure of 10 to 30 kg/cm. An excessively high roll pressure is undesirable, especially, when the press roller is made of a pair of rubber-made rollers or a combination of a metal-made roller and a rubber-made roller due to the possible deformation of the rubber-made roller or rollers under a high contacting pressure to cause appearance of creases or distortion in the resin films.

Although the essential steps in the inventive method for the preparation of a polyimide-fluorocarbon resin film laminate are the above described step (a), i.e. the low temperature plasma treatment of the resin films, and the step (b), i.e. press-bonding of the plasma-treated resin films into an integrated laminate at an elevated temperature, it is discovered that an additional improvement can be obtained in the laminate prepared by the steps (a) and (b) when the laminate is subjected to a heat treatment under a tensioned condition at a temperature of the softening point of the fluorocarbon resin or higher as an additional step (c) to such an extent that the polyimide and fluorocarbon resin films integrally bonded together are no longer separable or peelable to the respective base films. The temperature for this heat treatment should be 260 °C or higher or, preferably, in the range from 280 to 330 °C when the fluorocarbon resin is a copolymer of tetrafluoroethylene and hexafluoropropylene. It should be noted that the temperature increase to and temperature decrease from the above mentioned temperature for the heat treatment from or to room temperature are preferably performed stepwise since rapid increase and decrease of temperature may cause inclusion of air bubbles between the resin films. As is mentioned above, this heat treatment of the laminate must be performed under a tensioned condition of the laminate since absence of adequate tension in the heat treatment may cause distortion of the laminate as a result of the thermal shrinkage in the resin films. The tension on the laminate under the heat treatment should preferably be in the range from 0.01 to 0.3 kg/cm depending on the thickness and other parameters of the films. The heat treatment can be performed without pressing the laminate in the direction of bonding since the polyimide and fluorocarbon resin films once bonded together through the above described steps (a) and (b) are never separated in the course of this heat treatment.

As is described in the above, an integrated laminate of a polyimide resin film and a fluorocarbon resin film, e.g. a copolymeric resin film of tetrafluoroethylene and hexafluoropropylene, can be obtained by the inventive method comprising the steps (a), (b) and, optionally, (c). This method is very efficient in comparison with the conventional methods in the versatility in respect of the film thickness as well as in the absence of the troublesome procedure of coating with an aqueous dispersion of the fluorocarbon resin followed by drying and baking. Moreover, the bonding strength between the base resin films is unexpectedly high without air bubble inclusion, creases and distortion of the laminate. Therefore, the laminates prepared according to the inventive method are very useful in the applications as an insulating material in electric motors and power generators, electric wires and cables, substrate films for printed circuits, adhesive tapes for high temperature use, base bodies of plane heater elements and the like.

In the following, the method of the present invention is described in more detail by way of examples.

Example 1.

A plasma chamber of an apparatus for low temperature plasma treatment of a continuous-length film material was evacuated to a pressure of 0.01 Torr and then oxygen gas was introduced thereinto to produce a pressure of 0.1 Torr inside the chamber by the balance of the continuous evacuation and introduction of the gas. A polyimide resin film having a thickness of 50 $\mu$m was passed through the plasma chamber at a velocity of 30 meters/minute while low temperature plasma was generated therein by the impression of a high frequency electric power of 25 kilowatts at a frequency of 110 kHz between the electrodes to expose one of the surfaces of the polyimide resin film to the low temperature plasma.

A film of a copolymeric resin of tetrafluoroethylene and hexafluoropropylene having a thickness of 25 $\mu$m was subjected to a low temperature plasma treatment on one surface in the same manner as above except that the electric power impressed between the electrodes was 15 kilowatts, the velocity of the running film inside the chamber was 20 meters/minute and the atmosphere inside the plasma chamber was kept at a pressure of 0.3 Torr with air as the plasma-supporting gas instead of oxygen.

0185590

The resin films after the plasma treatment were laid one on the other with the plasma-treated surfaces contacting each with the other and passed together through a hot press roller of 40 cm width heated at 160 °C under a press load of 600 kg so that the resin films were firmly bonded together into a laminate. This laminate was absolutely free from inclusion of air bubbles and the bonding strength or peeling resistance between the polyimide resin film and the fluorocarbon resin film was 100 g/cm.

In the next place, the laminate was subjected to a heat treatment under a tensioned condition by passing through a heating tower kept at 300 °C taking 10 minutes of staying time therein. The resultant laminate having a thickness of 75 $\mu$m was free from air bubbles and creases and could no longer be separated by peeling into the base films of the polyimide resin and fluorocarbon resin.

Example 2.

A plasma chamber of an apparatus for low temperature plasma treatment of a continuous-length film material was evacuated to a pressure of 0.01 Torr and then nitrogen gas was introduced thereinto to produce a pressure of 0.05 Torr inside the chamber by the balance of the continuous evacuation and introduction of the gas. A polyimide resin film having a thickness of 75 $\mu$m was passed through the plasma chamber at a velocity of 10 meters/minute while low temperature plasma was generated therein by the impression of a high frequency electric power of 5 kilowatts at a frequency of 13.56 MHz between the electrodes to expose one of the surfaces of the polyimide resin film to the low temperature plasma.

A film of a copolymeric resin of tetrafluoroethylene and hexafluoropropylene having a thickness of 50 $\mu$m was subjected to a low temperature plasma treatment on one surface in the same manner as above except that the atmosphere inside the plasma chamber was kept at a pressure of 0.8 Torr with a 1:1 by volume mixture of oxygen and nitrogen as the plasma-supporting gas instead of nitrogen.

The resin films after the plasma treatment were laid one on the other with the plasma-treated surfaces contacting each with the other and passed together through a hot press roller of 40 cm width heated at 200 °C under a press load of 1000 kg so that the resin films were firmly bonded together into a laminate. This laminate was absolutely free from inclusion of air bubbles and the bonding strength or peeling resistance between the polyimide resin film and the fluorocarbon resin film was 700 g/cm.

In the next place, the laminate was subjected to a heat treatment under a tensioned condition by passing through a heating tower kept at 320 °C taking 7 minutes of staying time therein. The resultant laminate having a thickness of 125 $\mu$m was free from air bubbles and creases and could no longer be separated by peeling into the base films of the polyimide resin and fluorocarbon resin.

WHAT IS CLAIMED IS:

1. A method for the preparation of a laminate of films of a polyimide resin and a fluorocarbon resin which comprises the steps of:

(a) subjecting at least one of the surfaces of each of a polyimide resin film and a fluorocarbon resin film to a treatment with low temperature plasma of an inorganic gas; and

(b) pressing the thus plasma-treated films laid one on the other with the surfaces treated with low temperature plasma contacting with each other at an elevated temperature to integratethe films.

2. A method for the preparation of a laminate of films of a polyimide resin and a fluorocarbon resin which comprises the steps of:

(a) subjecting at least one of the surfaces of each of a polyimide resin film and a fluorocarbon resin film to a treatment with low temperature plasma of an inorganic gas;

(b) pressing the thus plasma-treated films laid one on the other with the surfaces treated with low temperature plasma contacting with each other at an elevated temperature to integratethe films; and

(c) subjecting the integrated body of the films to a heat treatment at a temperature of the softening point of the fluorocarbon resin or higher under a tensioned condition.

3.    The method for the preparation of a laminate of films of a polyimide resin and a fluorocarbon resin as claimed in claim 1 wherein the elevated temperature in the step (b) is in the range from 100 °C to the softening point of the fluorocarbon resin.

4.    The method for the preparation of a laminate of films of a polyimide resin and a fluorocarbon resin as claimed in claim 1 wherein the inorganic gas in the low temperature plasma treatment of the step (a) is oxygen, nitrogen or a mixture thereof.

5.    The method for the preparation of a laminate of films of a polyimide resin and a fluorocarbon resin as claimed in claim 2 wherein the temperature of the heat treatment in the step (c) is in the range from 280 to 330 °C.